(19) **Europäisches Patentamt / European Patent Office / Office européen des brevets**

(11) **EP 1 609 547 B1**

(12) **EUROPEAN PATENT SPECIFICATION**

(45) Date of publication and mention
of the grant of the patent:
**05.09.2007 Bulletin 2007/36**

(51) Int Cl.:
*B22F 1/00* (2006.01)     *H01B 1/16* (2006.01)
*H01B 1/22* (2006.01)     *B22F 9/24* (2006.01)

(21) Application number: **05012762.0**

(22) Date of filing: **14.06.2005**

(54) **Method for producing spherical silver powder with high shrinkage**

Prozess zur Herstellung von kugelförmigems Silberpulver mit hoher Schwindung

Procédé de production d'une poudre sphérique d'argent à retrait élevé

(84) Designated Contracting States:
**AT BE BG CH CY CZ DE DK EE ES FI FR GB GR HU IE IS IT LI LT LU MC NL PL PT RO SE SI SK TR**

(30) Priority: **18.06.2004 JP 2004181479**

(43) Date of publication of application:
**28.12.2005 Bulletin 2005/52**

(73) Proprietor: **Dowa Holdings Co., Ltd.**
**Chiyoda-ku**
**Tokyo (JP)**

(72) Inventors:
 • **Ogi, Kozo**
 **Honjo-shi**
 **Saitama 367-0021 (JP)**

 • **Fujino, Takatoshi**
 **Honjo-shi**
 **Saitama 367-0002 (JP)**

(74) Representative: **Manitz, Finsterwald & Partner GbR**
**Postfach 31 02 20**
**80102 München (DE)**

(56) References cited:
**EP-A- 0 249 366**     **EP-A- 1 083 578**
**EP-A- 1 398 101**     **US-A- 5 413 617**

**Description**

BACKGROUND OF THE INVENTION

Field of the Invention

The present invention generally relates to a method for producing a spherical silver powder. More specifically, the invention relates to a method for producing a spherical silver powder used for forming terminal electrodes of electronic parts, patterns of circuit boards and so forth.

Description of the Prior Art

In order to form electrodes and circuits of electronic parts and so forth, there has been used a conductive paste wherein a silver powder is dispersed in an organic component. Conductive pastes are generally classified into cermet type pastes (or pastes of a type to be fired) and polymer type pastes (or resin type pastes). The cermet type pastes have different uses and components from those of polymer type pastes.

A typical cermet type paste includes a silver powder, a vehicle containing ethyl cellulose or acrylic resin dissolved in an organic solvent, a glass frit, an inorganic oxide, an organic solvent, a dispersing agent and so forth as components. The cermet type paste is used for forming a conductor by firing after being formed so as to have a predetermined pattern by dipping, printing or the like. Such a cermet type paste is used for forming electrodes of hybrid ICs, multilayer ceramic capacitors, chip resistors and so forth.

The firing temperature of the cermet type paste varies in accordance with the use thereof. There are cases where a cermet type paste is fired at a high temperature on a heat resistant ceramic substrate, such as an alumina substrate for a hybrid IC or a glass-ceramic substrate, to form a conductor, and cases where a cermet type paste is fired at a low temperature on a substrate having a low heat resistance.

The specific resistivity of the sintered body of silver lowers if the paste is fired at a temperature as high as possible below the melting point of silver which is 960 °C. However, various problems are caused unless a silver powder suitable for the firing temperature is used. For example, if the paste is fired at a high temperature on a ceramic substrate, there are some cases where cracks and delamination are caused by a difference in shrinkage between the sintered body of silver and the ceramic substrate. In order to solve such problems, a high crystalline silver powder is proposed (see, e.g., Japanese Patent Laid-Open Nos. 2000-1706 and 2000-1707).

On the other hand, a typical polymer type paste is used as a wiring material, such as a through-hole or a membrane, a conductive adhesive or the like. Such a polymer type paste includes a silver powder, a thermosetting resin, such as an epoxy resin or urethane resin, a curing agent, an organic solvent, a dispersing agent and so forth as components. The polymer type paste is formed so as to have a predetermined conductive pattern by dispensing, printing or the like, and then, cured at a temperature ranging from a room temperature to about 250 °C, in order to obtain conductivity by causing silver particles to contact each other by the curing and shrinkage of the remaining resin. Therefore, in order to increase the contact area of silver particles contacting each other, there is generally used a flake-shaped silver powder which is obtained by mechanically working a silver powder in a scale shape. Furthermore, at a temperature above 300 °C, the resin is deteriorated, so that the conductivity and bond strength of the conductor are deteriorated.

However, for example, in the case of a plasma display panel (PDP) substrate, a glass being the material of the substrate has a low heat resistance, so that the paste can not be fired at a high temperature of about 750 to 900 °C unlike the case of the ceramic substrate. Therefore, it is required to fire the paste at a lower temperature, and it is required to form the conductor by firing the paste at a temperature of 600 °C or less in view of the heat resistance of the substrate, and at a low temperature of 500 to 600 °C in fact. Thus, it is difficult to lower the specific resistivity of the conductor.

When the paste is fired at a low temperature, if a glass frit having a lower softening point than the firing temperature is added to promote sintering, it is possible to lower the specific resistivity of the conductor. However, in the case of a PDP substrate formed by repeatedly carrying out firing, it is undesirable to use a glass frit having an excessively low softening point since the variation in specific resistivity of the conductor is caused.

In addition, when a silver powder is used for forming a photosensitive paste, if the silver powder has an undecided shape or a flake shape, the scattering and/or reflection of ultraviolet rays is caused, so that defective patterning is caused.

Moreover, when a conductive pattern is formed by another method, e.g., a printing or transferring method, if the silver powder has an undecided shape or a flake shape, it is not possible to form a good conductive pattern in view of the releasability from a screen plate and transferability.

EP 0 249 366 A1 discloses a process for the production of silver-palladium alloy fine powders that comprises adding hydrazine or a hydrazine compound to an acidic solution containing silver and palladium as ions and reduction-separating a silver-palladium alloy fine powder having an average particle diameter of 0.01 to 1.0 micron.

US 5,413,617 discloses a method for preparing a silver powder with a controlled surface area comprising the steps of i) providing a silver ion solution, ii) providing a mixed solution containing reducing agents and surfactants, iii) introducing the silver ion solution and the mixed solution at a certain flow rate into a low temperature reaction tank to obtain a reaction solution, iv) introducing the reaction solution into a high temperature tank and v) separating precipitated silver powder from the reaction solution after a period during which substantially no change in rest potential is observed.

SUMMARY OF THE INVENTION

It is therefore an object of the present invention to eliminate the aforementioned problems and to provide a method for producing a spherical silver powder which is capable of obtaining a good degree of sintering even if it is used for forming a paste to be fired at a low temperature of 600 °C or less to form a conductor. It is another object to provide a method for producing a spherical silver powder having a good dispersibility.

In order to accomplish the aforementioned and other objects, the inventors have diligently studied and found that, if a spherical silver powder which has a shrinkage of 5 to 15% at 500 °C and/or a shrinkage of 10 to 20% at 600 °C, and preferably which has a mean particle size of not greater than 5 $\mu$m, is used for forming a paste to be fired to form a conductor, it is possible to obtain a good degree of sintering even if the firing temperature is a low temperature of 600 °C or less, and it is possible to obtain a good conductive pattern by a photosensitive paste method, a printing method or a transferring method, from a paste using a spherical silver powder which has a good dispersibility, a tap density of not less than 2 g/cm$^3$ and a BET specific surface area of not greater than 5 m$^2$/g. Thus, the inventors have made the present invention.

According to the present invention, there is provided a method for producing a spherical silver powder with the aforementioned properties, wherein an aqueous solution containing a reducing agent is added to an aqueous solution or slurry containing silver ions, to deposit silver particles by reduction to produce the spherical silver powder, wherein said aqueous solution or slurry is an amine complex obtained by adding aqueous ammonia to an aqueous silver nitrate solution, wherein said reducing agent is at least one selected from the group consisting of ascorbic acid, alkanol amine, hydroquinone, hydrazine and formalin and wherein said aqueous solution containing the reducing agent is added at a rate of not lower than 1 equivalent/min with respect to the content of silver in said aqueous solution or slurry containing silver ions.

According to the present invention, it is possible to produce a spherical silver powder which has a good dispersibility and which is capable of obtaining a good degree of sintering even if it is used for forming a paste to be fired at a low temperature of 600 °C or less to form a conductor.

DESCRIPTION OF THE PREFERRED EMBODIMENTS

A preferred embodiment of a spherical silver powder produced by a method according to the present invention has a shrinkage of 5 to 15% at 500 °C, and/or a shrinkage of 10 to 20% at 600 °C, and preferably has a mean particle diameter of not greater than 5 $\mu$m. Such a silver powder can obtain a good degree of sintering even if it is used for forming a paste to be fired at a low temperature of 600 °C or less, so that it is possible to lower the specific resistivity of a conductor thus formed.

If the silver powder has a spherical shape, it can be suitably used for carrying out a photosensitive paste method. If the silver powder has an undecided shape or a flake shape, there is a disadvantage in that the photosensitive characteristics of the silver powder are not good since the irregular reflection and/or scattering of ultraviolet rays is caused. However, if the silver powder has a spherical shape, it is also suitably used for carrying out a printing or transferring method.

The spherical silver powder preferably has a tap density of 2 g/cm$^3$ or more, and a BET specific surface area of 5 m$^2$/g or less. If the tap density is less than 2 g/cm$^3$, the aggregation of particles of the silver powder is violently caused, so that it is difficult to form a fine line even if any one of the above described methods is used. If the BET specific surface area is greater than 5 m$^2$/g, the viscosity of the paste is too high, so that workability is not good.

In the method for producing a spherical silver powder according to the present invention, an aqueous solution containing a reducing agent is added to an aqueous solution or slurry containing silver ions, to deposit silver particles by reduction. A dispersing agent is preferably added an aqueous solution or slurry before or after the deposition of silver particles based on reduction.

As the aqueous solution or slurry or water reaction system respectively containing silver ions, an ammine complex obtained by adding aqueous ammonia to an aqueous silver nitrate solution is used so that the silver powder has an appropriate particle diameter and a spherical shape. Since the coordination number of the ammine complex is 2, 2 mol or more of ammonia per 1 mol of silver is added.

The reducing agent is selected from ascorbic acid, alkanol amine, hydrazine, hydroquinone, and formalin. If these reducing agents are used, it is possible to obtain silver particles having appropriate crystalline and appropriate particle diameters.

The reducing agent is added at a rate of 1 equivalent/min or more in order to prevent the aggregation of the silver powder. Although the reason for this is not clear, it is considered that, if the reducing agent is added in a short time, the deposition of silver particles by reduction is caused all at once to complete reduction in a short time, so that it is difficult to cause the aggregation of produced nuclei, thereby improving dispersibility. When reduction is carried out, the solution to be reacted is preferably agitated so as to complete the reaction in a shorter time.

The dispersing agent is preferably one or more selected from the group consisting of fatty acids, fatty acid salts, surface active agents, organometallic compounds, chelating agents and protective colloids. Examples of fatty acids include propionic acid, caprylic acid, lauric acid, myristic acid, palmitic acid, stearic acid, behenic acid, acrylic acid, oleic acid, linolic acid, and arachidonic acid. Examples of fatty acid salts include salts formed by fatty acids and metals, such as lithium, sodium, potassium, barium, magnesium, calcium, aluminum, iron, cobalt, manganese, lead, zinc, tin, strontium, zirconium, silver and copper. Examples of surface active agents include: anionic surface active agents, such as alkylbenzene sulfonates and polyoxyethylene alkyl ether phosphates; cationic surface active agents, such as aliphatic quaternary ammonium salts; amphoteric surface active agents, such as imidazolinium betaine; and nonionic surface active agents, such as polyoxyethylene alkyl ethers and polyoxyethylene fatty acid esters. Examples of organometallic compounds include acetylacetone tributoxyzirconium, magnesium citrate, diethylzinc, dibutyltin oxide, dimethylzinc, tetra-n-butoxyzirconium, triethyl indium, triethyl gallium, trimethyl indium, trimethyl gallium, monobutyl tin oxide, tetraisocyanate silane, tetramethyl silane, tetramethoxy silane, polymethoxy siloxane, monomethyl triisocyanate silane, silane coupling agent, titanate coupling agents, and aluminum coupling agents. Examples of chelating agents include imidazole, oxazole, thiazole, selenazole, pyrazole, isoxazole, isothiazole, 1H-1,2,3-triazole, 2H-1, 2, 3-triazole, 1H-1,2,4-triazole, 4H-1,2,4-triazole, 1,2,3-oxadiazole, 1,2,4-oxadiazole, 1,2,5-oxadiazole, 1,3,4-oxadiazole, 1,2,3-thiadiazole, 1,2,4-thiadiazole, 1,2,5-thiadiazole, 1,3,4-thiadiazole, 1H-1,2,3,4-tetrazole, 1,2,3,4-oxatriazole, 1,2,3,4-thiatriazole, 2H-1,2,3,4-tetrazole, 1,2,3,5-oxatriazole, 1,2,3,5-thiatriazole, indazole, benzoimidazole, benzotriazole and salts thereof, and oxalic acid, succinic acid, malonic acid, glutaric acid, adipic acid, pimelic acid, suberic acid, azelaic acid, sebacic acid, didodecanoic acid, maleic acid, fumaric acid, phthalic acid, isophthalic acid, terephthalic acid, glycolic acid, lactic acid, hydroxy butyric acid, glyceric acid, tartaric acid, malic acid, tartronic acid, hydracrylic acid, mandelic acid, citric acid and ascorbic acid. Examples of protective colloids include gelatin, albumin, gum arabic, protarbic acid and lysalbic acid.

The spherical silver powder thus obtained may be processed by a surface smoothing process which mechanically causes particles to collide with each other, and then, silver agglomerates may be removed from the spherical silver powder by a classification. If the spherical silver powder thus obtained is used for forming a photosensitive paste, the sensitivity of the photosensitive paste thus formed is good, and the linearity of the pattern thus obtained is very good, so that it is possible to obtain a fine pattern. The silver powder thus obtained has an excellent releasability from a printing plate if it is used for carrying out a printing method, and has an excellent transferability if it is used for carrying out a transferring method, so that the silver powder can be suitably used for carrying out various methods.

Examples of a spherical silver powder and a method for producing the same according to the present invention will be described below in detail.

Example 1

To 3600 ml of an aqueous solution containing 12 g/l silver nitrate as silver ions, 300 ml of industrial aqueous ammonia was added to form an aqueous silver ammine complex solution. To the aqueous silver ammine complex solution thus formed, 60 g of sodium hydroxide was added to control the pH of the solution. Then, 90 ml of industrial formalin serving as a reducing agent was added to the solution in 10 seconds. Immediately thereafter, 0.5 g of stearic acid emulsion was added to the solution to obtain a silver slurry. Then, the silver slurry thus obtained was filtered, washed with water, dried to obtain a silver powder. Then, the surface of the silver powder thus obtained was smoothed by a surface smoothing process using a high-speed mixer, and the silver powder thus smoothed was classified to remove silver agglomerates having a greater diameter than 8 $\mu$m.

The shrinkage, BET specific surface area, tap density and mean particle diameter $D_{50}$ (Microtrack) of the silver powder thus obtained were measured, and the conductivity thereof was evaluated. Furthermore, it was confirmed by a scanning electron microscope (SEM) that the silver powders obtained in this example and in examples and comparative examples described later were spherical silver powders.

The shrinkage of the silver powder was obtained from the following expressions by measuring the length of a pellet-like sample of silver powder, which is prepared by loading the silver powder in a die and which has a diameter of 5 mm, when it is heated from 50 °C to 600 °C at a temperature rising rate of 10 °C/min.:

$$\text{Shrinkage (\%) at 500 }^{\circ}\text{C} = (L_{50} - L_{500})/L_{50} \times 100$$

$$\texttt{Shrinkage (\%) at 600 ℃ = (L}_{50}\texttt{-L}_{600}\texttt{)/L}_{50}\texttt{ x 100}$$

wherein Lso, $L_{500}$ and $L_{600}$ are the lengths (mm) of the pellet-like sample of silver powder when the temperature of the sample is 50 °C, 500 °C and 600 °C, respectively.

The evaluation of the conductivity was carried out as follows. First, 65 parts by weight of the silver powder, 14 parts by weight of an acrylic resin (BR-105 commercially available from Mitsubishi Rayon Co., Ltd.), 21 parts by weight of an organic solvent (diethylene glycol monoethyl ether acetate (reagent)), and 1 part by weight of a glass frit (GA-8 commercially available from Nippon Electric Glass Co., Ltd.) were measured to be kneaded by a three-roll mill to prepare a paste. Then, the paste was printed on a commercially available soda glass substrate to be fired at 550 °C for ten minutes to obtain a sintered body. The conductivity of the sintered thus obtained was evaluated. It was evaluated that the conductivity was good if the specific resistivity of the sintered body was not greater than 3 x $10^{-6}$ Ω · cm and was stable, and that the conductivitywas not good if the specific resistivity of the sintered body was greater than 3 x $10^{-6}$ Ω · cm or was not stable.

As a result, the shrinkage at 500 °C was 8.6%, and the shrinkage at 600 °C was 12.4%. In addition, the BET specific surface area was 0.75 $m^2/g$, the tap density was 5.0 $g/cm^3$, and the mean particle diameter $D_{50}$ was 1.4 μm. Moreover, the conductivity was good.

Example 2

To 3600 ml of an aqueous solution containing 12 g/l silver nitrate as silver ions, 180 ml of industrial aqueous ammonia was added to form an aqueous silver ammine complex solution. To the aqueous silver ammine complex solution thus formed, 7 g of sodium hydroxide was added to control the pH of the solution. Then, 192 ml of industrial formalin serving as a reducing agent was added to the solution in 10 seconds. Immediately thereafter, 0.1 g of oleic acid was added to the solution to obtain a silver slurry. Then, the silver slurry thus obtained was filtered, washed with water, dried to obtain a silver powder. Then, the silver powder thus obtained was pulverized by a food mixer.

With respect to the silver powder thus obtained, the measurement of shrinkage at 500 °C and 600 °C, BET specific surface area, tap density and mean particle diameter $D_{50}$, and the evaluation of conductivity were carried out by the same methods as those in Example 1. As a result, the shrinkage at 500 °C was 7.8%, and the shrinkage at 600 °C was 13.1%. In addition, the BET specific surface area was 0.46 $m^2/g$, the tap density was 4.7 $g/cm^3$, and the mean particle diameter $D_{50}$ was 2.1 μm. Moreover, the conductivity was good.

Example 3

To 3600 ml of an aqueous solution containing 12 g/l silver nitrate as silver ions, 180 ml of industrial aqueous ammonia was added to form an aqueous silver ammine complex solution. To the aqueous silver ammine complex solution thus formed, 1 g of sodium hydroxide was added to control the pH of the solution. Then, 192 ml of industrial formalin serving as a reducing agent was added to the solution in 15 seconds. Immediately thereafter, 0.1 g of stearic acid was added to the solution to obtain a silver slurry. Then, the silver slurry thus obtained was filtered, washed with water, dried to obtain a silver powder. Then, the surface of the silver powder thus obtained was smoothed by a surface smoothing process using a high-speed mixer, and the silver powder thus smoothed was classified to remove silver agglomerates having a greater diameter than 11 μm.

With respect to the silver powder thus obtained, the measurement of shrinkage at 500 °C and 600 °C, BET specific surface area, tap density and mean particle diameter $D_{50}$, and the evaluation of conductivity were carried out by the same methods as those in Example 1. As a result, the shrinkage at 500 °C was 8.0%, and the shrinkage at 600 °C was 14.3%. In addition, the BET specific surface area was 0.28 $m^2/g$, the tap density was 5.4 $g/cm^3$, and the mean particle diameter $D_{50}$ was 3.1 μm. Moreover, the conductivity was good.

Example 4

To 3600 ml of an aqueous solution containing 12 g/l silver nitrate as silver ions, 150 ml of industrial aqueous ammonia was added to form an aqueous silver ammine complex solution. To the aqueous silver ammine complex solution thus formed, 13 ml of industrial hydrazine serving as a reducing agent was added to the solution in 2 seconds. Immediately thereafter, 0.2 g of oleic acid was added to the solution to obtain a silver slurry. Then, the silver slurry thus obtained was filtered, washed with water, dried to obtain a silver powder. Then, the surface of the silver powder thus obtained was smoothed by a surface smoothing process using a high-speed mixer.

With respect to the silver powder thus obtained, the measurement of shrinkage at 500 °C and 600 °C, BET specific surface area, tap density and mean particle diameter $D_{50}$, and the evaluation of conductivity were carried out by the same methods as those in Example 1. As a result, the shrinkage at 500 °C was 14.5%, and the shrinkage at 600 °C was 16.1%. In addition, the BET specific surface area was 0.86 $m^2/g$, the tap density was 4.0 $g/cm^3$, and the mean particle diameter $D_{50}$ was 1.7 $\mu$m. Moreover, the conductivity was good.

Comparative Example 1

To 3600 ml of an aqueous solution containing 6 g/l silver nitrate as silver ions, 50 ml of industrial aqueous ammonia was added to form an aqueous silver ammine complex solution. To the aqueous silver ammine complex solution thus formed, 60 ml of industrial aqueous hydrogen peroxide serving as a reducing agent was added to the solution in 15 seconds. Immediately thereafter, 0.1 g of sodium stearate was added to the solution to obtain a silver slurry. Then, the silver slurry thus obtained was filtered, washed with water, dried to obtain a silver powder.

With respect to the silver powder thus obtained, the measurement of shrinkage at 500 °C and 600 °C, BET specific surface area, tap density and mean particle diameter $D_{50}$, and the evaluation of conductivity were carried out by the same methods as those in Example 1. As a result, the shrinkage at 500 °C was 2.2%, and the shrinkage at 600 °C was 8.4%. In addition, the BET specific surface area was 0.15 $m^2/g$, the tap density was 5.0 $g/cm^3$, and the mean particle diameter $D_{50}$ was 6.5 $\mu$m. Moreover, the conductivity was not good.

Comparative Example 2

With respect to a commercially available atomized silver powder (5 $\mu$m), the measurement of shrinkage at 500 °C and 600 °C, BET specific surface area, tap density and mean particle diameter $D_{50}$, and the evaluation of conductivity were carried out by the same methods as those in Example 1. As a result, the shrinkage at 500 °C was -0.7%, and the shrinkage at 600 °C was -0.3%. In addition, the BET specific surface area was 0.21 $m^2/g$, the tap density was 5.2 $g/cm^3$, and the mean particle diameter $D_{50}$ was 5.3 $\mu$m. Moreover, the conductivity was not good.

These results are shown in Table. In Table, conductivity is shown by "good" if the evaluation of conductivity is good, and conductivity is shown by "no good" if the evaluation of conductivity is not good.

Table

| | Shrinkage (%) at 500°C | Shrinkage (%) at 600°C | BET ($m^2/g$) | Tap Density ($g/cm^3$) | $D_{50}$ ($\mu$m) | Conductivity |
|---|---|---|---|---|---|---|
| Ex.1 | 8.6 | 12.4 | 0.75 | 5.0 | 1.4 | good |
| Ex.2 | 7.8 | 11.0 | 0.46 | 4.7 | 2.1 | good |
| Ex.3 | 8.0 | 14.3 | 0.28 | 5.4 | 3.1 | good |
| Ex.4 | 14.5 | 16.1 | 0.86 | 4.0 | 1.7 | good |
| Comp.1 | 2.2 | 8.4 | 0.15 | 5.0 | 6.5 | no good |
| Comp.2 | -0.7 | 0.3 | 0.21 | 5.2 | 5.3 | no good |

**Claims**

1. A method for producing a spherical silver powder, wherein an aqueous solution containing a reducing agent is added to an aqueous solution or slurry containing silver ions, to deposit silver particles by reduction to produce the spherical silver powder,
   wherein said aqueous solution or slurry is an amine complex obtained by adding aqueous ammonia to an aqueous silver nitrate solution,
   wherein said reducing agent is at least one selected from the group consisting of ascorbic acid, alkanol amine, hydroquinone, hydrazine and formalin, and
   wherein said aqueous solution containing the reducing agent is added at a rate of not lower than 1 equivalent/min with respect to the content of silver in said aqueous solution or slurry containing silver ions.

2. A method for producing a spherical silver powder as set forth in claim 1, wherein a dispersing agent is added to the aqueous solution or slurry before or after said silver particles are deposited.

3. A method for producing a spherical silver powder as set forth in claim 2, wherein said dispersing agent is at least one selected from the group consisting of fatty acids, fatty acid salts, surface active agents, organometallic compounds, chelating agents and protective colloids.

4.  A method for producing a spherical silver powder as set forth in claim 1, wherein a surface of said spherical silver powder is smoothed by a surface smoothing process which mechanically causes particles to collide with each other.

5.  A method for producing a spherical silver powder as set forth in claim 4, wherein silver agglomerates are removed from the spherical, powder silver by a classification after said surface smoothing process.


**Patentansprüche**

1.  Verfahren zum Herstellen eines kugelförmigen Silberpulvers, bei dem eine ein Reduktionsmittel enthaltende wässrige Lösung zu einer wässrigen Lösung oder Aufschlämmung, welche Silberionen enthält, zugegeben wird, um Silberpartikel durch Reduktion abzuscheiden, um das kugelförmige Silberpulver herzustellen,
    wobei die wässrige Lösung oder Aufschlämmung ein durch Zugabe von wässrigem Ammoniak zu einer wässrigen Silbernitratlösung erhaltener Aminkomplex ist,
    wobei das Reduktionsmittel wenigstens eine aus der aus Ascorbinsäure, Alkanolamin, Hydrochinon, Hydrazin und Formalin bestehenden Gruppe ausgewählte Verbindung ist, und,
    wobei die wässrige Lösung, welche das Reduktionsmittel enthält, bei einer Geschwindigkeit von nicht weniger als 1 Äquivalent/Min. bezogen auf den Silbergehalt in der wässrigen Lösung oder Aufschlämmung, welche Silberionen enthält, zugegeben wird.

2.  Verfahren zum Herstellen eines kugelförmigen Silberpulvers nach Anspruch 1, wobei zu der wässrigen Lösung oder zu der Aufschlämmung ein Dispersionsmittel zugegeben wird, bevor oder nachdem die Silberpartikel abgeschieden werden.

3.  Verfahren zum Herstellen eines kugelförmigen Silberpulvers nach Anspruch 2, wobei das Dispersionsmittel wenigstens eines ist ausgewählt aus der Gruppe bestehend aus Fettsäuren, Fettsäuresalzen, oberflächenaktiven Substanzen, organometallischen Verbindungen, Chelatmitteln und Schutzkolloiden.

4.  Verfahren zum Herstellen eines kugelförmigen Silberpulvers nach Anspruch 1, wobei eine Oberfläche des kugelförmigen Silberpulvers durch einen Oberflächenglättungsprozess geglättet wird, welcher mechanisch verursacht, dass Partikel miteinander kollidieren.

5.  Verfahren zum Herstellen eines kugelförmigen Silberpulvers nach Anspruch 4, wobei die Silberagglomerate aus dem kugelförmigen Silberpulver durch Klassifikation nach dem Oberflächenglättungsverfahren entfernt werden.


**Revendications**

1.  Procédé de production d'une poudre d'argent sphérique, dans lequel une solution aqueuse contenant un agent de réduction est ajoutée à une solution ou à une suspension aqueuse contenant des ions argent, en vue de déposer des particules d'argent par réduction permettant de produire une poudre d'argent sphérique,
    dans lequel ladite solution ou suspension aqueuse est un complexe d'amine obtenu en ajoutant de l'ammoniac aqueux à une solution aqueuse de nitrate d'argent,
    dans lequel ledit agent de réduction est au moins un élément sélectionné dans le groupe se composant d'acide ascorbique, d'alcanolamine, d'hydroquinone, d'hydrazine et de formaline, et
    dans lequel ladite solution aqueuse contenant l'agent de réduction est ajoutée à une vitesse d'au moins 1 équivalent/minute en tenant compte de la teneur en argent de ladite solution ou suspension aqueuse contenant des ions argent.

2.  Procédé de production d'une poudre d'argent sphérique selon la revendication 1, dans lequel un agent de dispersion est ajouté à la solution ou à la suspension aqueuse avant ou après le dépôt desdites particules d'argent.

3.  Procédé de production d'une poudre d'argent sphérique selon la revendication 2, dans lequel ledit agent de dispersion est au moins un élément sélectionné dans le groupe se composant d'acides gras, de sels d'acides gras, d'agents tensioactifs, de composés organométalliques, de chélateurs et de colloïdes protecteurs.

4.  Procédé de production d'une poudre d'argent sphérique selon la revendication 1, dans lequel une surface de ladite poudre d'argent sphérique est polie par un procédé d'uniformisation de la surface qui provoque des entrechoquements des particules de manière mécanique.

5. Procédé de production d'une poudre d'argent sphérique selon la revendication 4, dans lequel des agglomérats d'argent sont supprimés de la poudre d'argent sphérique par classification après ledit procédé d'uniformisation de la surface.

**REFERENCES CITED IN THE DESCRIPTION**

**Patent documents cited in the description**

- JP 2000001706 A
- JP 2000001707 A
- EP 0249366 A1
- US 5413617 A